# EUROPEAN PATENT APPLICATION

(11) **EP 1 947 511 A1**
(43) Date of publication of application: **23.07.2008**
(21) Application number: 06795472.7
(22) Date of filing: 08.09.2006
(51) Int. Cl.: G03F 7/20, G03F 9/00

(54) **PROCESS FOR THE MANUFACTURE OF PRINTING SUPPORT FOR ROLLERS FOR THE PRINTING OF LAMINAR MATERIALS, MACHINE FOR IMPLEMENTING THE PROCESS AND THE PRINTING SUPPORT FOR PRINTING ROLLERS**

(30) Priority: 12.09.2005 ES 200502200
(71) Applicant: Ruggiero, Ricardo Angel, 2000 Rosario (AR); Nasini, Alfredo Carlos, CP 2000 Rosario Pcia. de Santa Fe (AR)
(72) Inventor: RUGGIERO, Ricardo Angel, Santa Fe, 2000 Rosario (AR)
(74) Representative: Durán Moya, Luis-Alfonso
(86) International application number: PCT/IB2006/002508
(87) International publication number: WO 2007/031842

(57) **Abstract**

A process for the manufacture of rollers for the printing of laminar materials, a machine for carrying out the process and a printing support for printing rollers.

A printing support is wholly manufactured within an irradiating machine equipped with visible marks located on the lower plate and on the machine. The laminar support supports the plates positioned on a dimensionally stable substrate sheet on which marks are made accurately in the same location relative to the overall image as a reference axis for subsequent positioning on the roller and on which also matching marks are printed or engraved. Some of these marks are repeated on films which restrict the passage of ultraviolet light, one of the films having transparent areas which present elements of one colour of the image which has to be printed while the remaining film represents mounts surrounding such elements.

## Description

This invention relates to a process for the manufacture of rollers intended for the printing of laminar materials, in particular corrugated cardboard, and a machine for implementing the said process and a laminar printing support intended for application to a supporting core for the formation of printing rollers.

This invention relates to the printing of marks on sheets of corrugated material, in particular the printing of advertising graphic marks in the manufacture of corrugated cardboard boxes, more particularly in relation to images having more than one colour. Corrugated cardboard boxes printed in this way are used commercially for the distribution of a great variety of products and articles such as cosmetics, medications, foods, books, vehicle spare parts, electrical domestic appliances, etc.

It is common practice to print boxes with marks identifying the contents and nature of the same, bar codes which identify their origin, as well as graphics and logos which are also usually of an advertising nature. To print such multicolour marks use is made of a machine provided with two or more plate-bearing rollers through which the corrugated cardboard passes in succession, fed as unfolded (open) sheets, these rollers preceding a final roller fitted with knives to emboss the cardboard sheet at the future edges which will form the folds between the surfaces of the boxes. Each roller prints a particular colour, for which purpose it is provided with a laminar printing support or "mantle" which contains the plates representing the elemental marks of corresponding colour secured into corresponding positions in such a way that they can be printed onto the cardboard once the printing roller has been inked.

The laminar printing supports comprise sheets of polyester or other dimensionally stable material of a size generally covering the area of the unfolded box. The plates corresponding to the individual single-colour image elements which make up the multi-colour images on the box after passing through successive rollers are positioned on this sheet. The plates are manufactured on the basis of a design generally prepared by computer using specific graphic design programs in which the various image elements are available broken down into the corresponding colours. The design may be drawn directly using a mouse or other computer tools or may be scanned from a sample provided by a customer. Once this has been done the computer converts the design into negatives from which the printing plates are manufactured.

The plates may be manufactured using liquid resin which is subjected to a selective radiation process using the said negatives to form the plates.

For reasons mainly of economy and handling, given the size of the unfolded box and the fact that printing hardly ever covers its entire area, the design is subdivided into parts giving rise to multiple individual plates which are manufactured on sheets of photopolymer which then have to be manually placed on the laminar support with very great precision. Given that register errors may cause part of the image in one colour to move over the box in relation to the relative position of the matching part of the image of the other colour, it is important that the two colours should be in precise register with each other and in precise register with the embossing of the sheet of corrugated cardboard when it leaves the printing machine.

For the reasons just stated it is important that such printing should be clear and accurately located, particularly when there are areas where two or more colours are present. In these areas the colours must be in precise register, that is to say one colour should coincide with or be superimposed on the other to a predetermined amount, avoiding leaving visible spaces in-between. Millimetre shifts, including sub-millimetre shifts, in one of the colours relative to the other are clearly visible and help to spoil the appearance of the box and undermine the advertising purpose.

### Background to the invention

According to a process which has been known for very many years, the work of fitting and attaching plates to the laminar support is carried out by hand using the expertise of skilled labour following a trial and error process. More recently, both the accuracy and speed of fitting, and ultimately economy, have been substantially improved through the process developed in Argentine patent no. AR 4.439 B1 and US patent no. 5,752,445, which uses printing images available in computer files to manufacture the plates, using computer tools to separate the available image, generating a file for each colour with the parts of the image corresponding to that colour. The error introduced by the radius of curvature of the roller is compensated for either previously or subsequently. Each of these compensated single-colour files is then used to print visible indicators on each laminar printing support before the latter is fitted to the corresponding roller. These indicators may comprise solid or fragmentary lines of the image in the same colour or coordinated marks which identify the positions of the various plates, for example centered crosses and ordinal numbers associated with the position of each plate, avoiding all actual representation of the image if desired.

Before the corresponding laminar support is mounted on the corresponding roller, the resin plates, each of which represents an element or part of the single-colour sub-image, are fitted, securing each plate onto the laminar support in the precise positions identified by the lines or indicators. Each laminar support is thus mounted with its plates in the positions specified by the indicators before the laminar printing supports are fitted to the corresponding rollers.

The method disclosed in the abovementioned patents, Argentinian patent no. AR 4.439 B1 and US patent no. 5,752,445, reduces the time for fitting the corresponding plates to each of the rollers, which helps to reduce the cost of the printing substrates intended to be boxes for the packaging of articles without having any adverse effects on the accuracy and quality of the work, improving the quality of printing on the substrates or boxes of corrugated material, in particular the register between the colours of the image and their relationship to the edges of the box, without increasing machine time, and placing parts of the image, in particular parts corresponding to different colours, in register without requiring multiple positioning trials, in addition to compensating directly for any asymmetry errors originating from the cylindrical curvature of the rollers when fitting.

However, because of the fact that the plates then have to print onto a corrugated substrate, in practice the laminar polyester support is provided with a substrate having a resilient memory, such as a photopolymer sheet 7 mm or less thick, in order to provide the necessary resilience for adequate penetration of the corrugations. The use of photopolymer sheets represents a major cost, which the invention reduces.

### Characteristics of the invention:

The objects of this invention mainly include elimination of the manual work for fitting the cast or cured resin plates onto the substrates of the laminar printing supports, thus further increasing the accuracy of the register between the colours and the positioning of the latter between the folds forming the edges of the sides of the box, improving readying the printing machine to start printing by fitting the laminar supports to the plate-holding cylinders or printing rollers, together with an appreciable saving in the resin used to manufacture the plates, all of this bringing about a reduction in material and operating costs and improving the final results. This invention makes it possible to avoid the use of photopolymer material by reducing the quantity of resin required to form each plate with a base or bottom of predetermined shape directly in contact with the substrate of the laminar printing support.

These and other objects and advantages of this invention are obtained through a process for the manufacture of a laminar support which is carried out wholly within an irradiating machine, especially a UV machine, from which the laminar supports exit with the final form and conformation of the substrate of the plates attached in precise positions. In order to put this process into effect a series of visible marks or indicators are incorporated in the machine, their arrangement coinciding with supplementary indicators inscribed or engraved on the substrates of the laminar supports and, if appropriate, other components. In a preferred embodiment these additional components comprise filtering or restricting devices in the form of photonegative films, for example, which ensure accurate prepositioning of the components prior to the irradiation process.

As will be appreciated from the detailed description which follows, the procedure for each colour comprises, briefly:
- having a dimensionally stable transparent sheet which forms the laminar supporting substrate onto which the guide marks which permit the manufactured laminar support to be accurately positioned on the plate-holding cylinders of the printing machine have been incorporated in advance, in addition to the abovementioned marks or indicators matching those on the irradiating machine,
- forming a pair of irradiated light filter and/or restrictor devices, such as for example producing corresponding graphic photonegative films of the colour which has to be printed, one with the precise images which have to be reproduced and the other additional one with outlines surrounding such images in order to define bases or mounts matching these images, incorporating the said sets of marks or indicators matching those on the machine in the films,
- positioning one of the photonegative films on the lower glass of the abovementioned irradiating machine, causing the said marks or indicators on the photonegative film to coincide with those on the machine,
- pouring liquid resin onto the said glass, in a layer of controlled thickness, placing a protective laminar sheet or film on the negative, positioning the dimensionally stable transparent sheet comprising the substrate of the laminar support, causing the said marks or indicators matching those on the machine and those on the restrictive film to coincide,
- positioning the other photonegative film of the pair corresponding to this colour in a similar way, using the marks so that both photonegative films are in precise vertical register with each other and with the substrate sheet,
- with the photonegative films and the substrate sheet immobilised in the marked positions, successively irradiating from above and below until the resin is cured in regions corresponding to the said image(s) and base(s) or mount(s).
   The procedures unavoidable in the prior art, such as positioning and securing and/or fitting each plate to the substrate manually, are thus replaced.
   After the irradiation stage mentioned, the resin which is still liquid and uncured is removed, allowing it to be recovered for reuse, which also means a significant additional saving, and the resulting laminar support together with the cured material adhering to the dimensionally stable sheet which acts as the substrate for the laminar support is removed. In the same way the laminar support for the second colour and any others which are necessary are manufactured in such a way that their marks are in register with each other for the process of printing the corrugated material. The machine for carrying out the process will be a luminous irradiating machine of a known type, especially a machine for irradiation with ultraviolet light using upper and lower crystal or "glass" panels, of which the lower is fixed and the upper tilts together with a tilting body which forms the cover of the machine, being characterised according to this invention in that it bears centering or register marks or lines for all the elements which have to coincide in vertical projection, such as the laminar polyester substrate and the two negative or light "restrictor" laminar elements which are in contact with the upper and lower crystal or glass plate respectively in order to delimit the areas which have to be irradiated. The marks or indicators are located outside the radiation field of the machine in order not to interfere with it.
   The marks on the fixed parts of the machine correspond with the marks made in a corresponding way on the negative plates and the laminar support which will form the laminar printing or plate-holding element.
   Likewise the laminar printing element or plate-holding support will have marks, preferably in the form of coordinated axes for precisely positioning the previously manufactured laminar printing element on the cylindrical core or roller in such a way that after fitting a plate-holding roller or printing roller which can then be mounted on the printing machine is obtained directly.
   As will be understood, the invention therefore also extends to the printing support for the printing rollers which will comprise a single substrate bearing all the printing plates required to make up a printing roller, which can then be simply incorporated onto a core in the form of a roller combining very precisely with the printing roller, simply and with a great reduction in labour in comparison with the known art.
   However this invention also provides for the alternative of manufacturing multiple laminar supports side by side for two or more colours or printing jobs in a single process cycle if an irradiating machine of sufficient size relative to the size of the laminar supports is available.
   The possibility of producing a composite sheet at the start of the procedure which incorporates the substrate sheet with one of the restrictor films may also be envisaged. On the side of the substrate sheet opposite that to which the resin adheres a sheet such as for example paper, vinyl or other material which blocks the passage of ultraviolet light, thus acting as a restricting device or restrictor, is applied. This laminar element is cut to the outline shapes corresponding to each image element and when the cut material is removed reveals the transparency of the substrate combined with dimensional stability, thus permitting irradiating light to pass through in order to form the foundations or bases for supporting the abovementioned images. Use of this composite substrate layer makes it possible to eliminate the step in the procedure relating to the positioning of one of the restrictor devices, in particular the photonegative film corresponding to the outlines.

### Brief description of the drawings:

Other advantages and characteristics of the present invention will become clear from the following detailed description which is given by way of example, with reference to the appended drawings which are provided purely by way of non-limiting examples and in which:
Figure 1 A illustrates a prime object of the invention, precise register between the joining parts of the image of different colour. Conversely, Figures 1B and 1C illustrate register errors which the process according to the invention overcomes.
Figure 2 is a block diagram explaining the stage of designing and generating the restrictor devices in the form of photonegative films with monochromatic images and the substrates then used in the subsequent manufacture of laminar supports according to an embodiment of the invention.
Figure 3 illustrates an irradiating machine adapted to carry out the process according to this invention for the manufacture of laminar printing supports.
Figure 4A is a perspective diagram of the irradiating machine in Figure 3, illustrated with the first filter film already in position and with the substrate position on one side and on the point of being unrolled by the carriage.
Figure 4B is a diagram similar to Figure 4A which illustrates the machine after passage of the carriage and positioning of the second filter film before starting the irradiation stage.
Figures 5A and 5B illustrate a pair of matching laminar printing supports corresponding to two different colours in the image obtained by two complete passes or cycles through the machine in Figure 3.
Figure 6 is a transverse cross-section through the laminar support in Figure 5A or 13 corresponding to the laminar support according to its longitudinal median plane 26Y.
Figure 7 is a diagram of the printing machine, illustrating the feed of cardboard sheets to its rollers and also the final roller for embossing the cardboard.
Figures 8A and 8B illustrate the corresponding laminar printing supports in Figures 5A and 5B fitted to the respective rollers of the printing machine in Figure 8.
Figure 9 illustrates the sheet which forms the substrate of the laminar support with its marks as positioning indicators in the irradiating machine and with the prefixed coordinated marks in precisely the same relative location to the overall image for mounting the laminar support on its plate-holding cylinder or printing rollers in the printing machine.
Figure 10 is a block diagram similar to Figure 2 of the stage of designing and producing the photonegative films of necessary size to contain the monochromatic images for different colours and the substrate then used for the simultaneous manufacture of laminar supports for different colours according to an alternative embodiment of the process according to the invention.
Figure 11 is a perspective diagram of the irradiating machine such as in Figure 4B for the manufacture of laminar printing supports, illustrating the use of devices such as the photonegative films and the substrate generated in Figure 10, all having sufficient dimensions for the simultaneous manufacture of laminar supports for the printing of different colours.
Figure 12 illustrates in a manner similar to Figure 9 the substrate or sheet generated in the stage in Figure 10 which is used in the irradiating machine in Figure 11 for the simultaneous manufacture of multiple laminar supports according to the said alternative embodiment of the process according to the invention.
Figure 13 illustrates laminar printing supports for different complementary colours with their cutting or separation line manufactured simultaneously through one pass or complete cycle through the machine in Figure 11 or 15.
Figure 14 is a block diagram similar to Figures 2 and 10 of the stage of designing and producing materials for any of the sequential or simultaneous procedures in the preceding figures, including a composite sheet which combines a substrate for the laminar support with the laminated element which selectively restricts or filters the irradiating light in accordance with another embodiment of this invention.
Figure 15 is a perspective diagram of the irradiating machine in Figure 11 which illustrates the arrangement of the composite sheet obtained in the stage in Figure 14 for the manufacture of laminar printing supports.
Figure 16A illustrates the reverse side of the sheet or composite laminated substrate in Figure 16B.
Figure 16B illustrates the composite sheet obtained in Figure 14 formed as a transparent substrate with dimensional stability whose side opposite that bearing adhesive or treated for adhesion of the photopolymer or liquid resin has the laminate blocking the passage of ultraviolet light, illustrating the cuts to permit passage of the said light for the outline shapes corresponding to each image element and the cuts for displaying the marks for positioning the same in the irradiating machine according to Figure 15.
Figure 17 shows matching printing laminar supports for different colours manufactured at the same time or simultaneously, using the composite substrate sheet in Figure 16B in this process and illustrates removal of the laminated blocking element during the irradiation or curing process in the irradiating machine.
In the figures the same reference numbers are used to identify the same or equivalent parts, omitting the alphabetic suffixes of the reference numbers in order to render them general in general cases. For example, if a number "22A" relates to the blue laminar support and "22B" to the black, "22" is used when the reference makes no distinction, is common or applies to both.

### Detailed description of preferred embodiments:

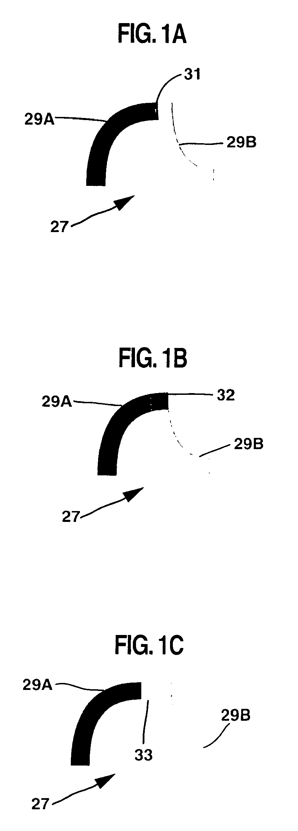

The method according to the invention makes it possible to obtain formed and shaped laminar supports which are completely ready for printing in precise register, which are essential to obtaining printed boxes of good quality for the packaging of products. The importance of this accuracy is shown graphically in Figures 1A, 1B and 1C.

Figure 1A illustrates a possible two-colour graphic design -27- comprising for example a sub-image -29A- of a blue colour and another sub-image -29B- of a black colour. According to the specifications provided by the customer for printing the corrugated cardboard boxes, both sub-images -29- of different colour must be in register, that is, a join -31- between one colour and the other should be without any visible break in continuity. Given that each colour is printed on the cardboard separately, any displacement in the printing of one colour with respect to the other could result in an overlap -32- of the blue on the black as illustrated in Figure 1B or could leave a gap -33- between the two sub-images -29- as shown in Figure 1C.

Both defects -32- and -33- are undesirable and may be repeated throughout a batch of printed boxes, giving rise to rejection of all the work by the customer, with the consequent loss of time and materials. However, the overlap defect -32- between the two sub-images -29- as illustrated in Figure 1B is visually better than the gap -33- illustrated in Figure 1C, provided that it does not approach and even less so project on the other side, for which reason it is good practice to provide for a small overlap between the two sub-images -29-, for example up to halfway through the thickness of the line.

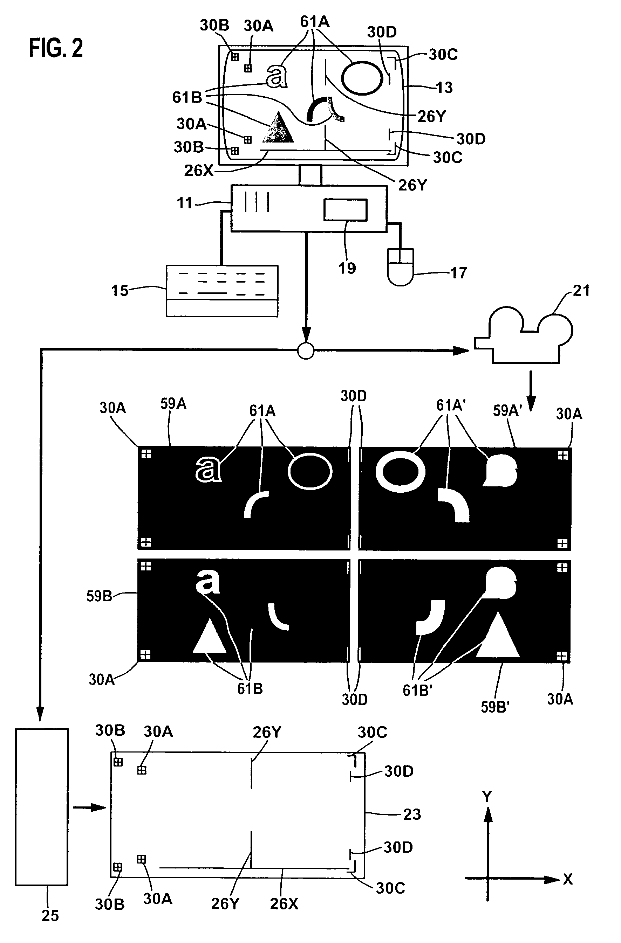

Figure 2 shows a computer -11- of the Macintosh type or any of those known as IBM PC compatible computers. Computer -11- is suitably programmed, for example using one of the softwares known commercially as Adobe Photoshop, Adobe Illustrator, QuarkXpress, FlexiSing-Pro, CorelDraw, Adobe Acrobat Distiller, Adobe Acrobat Reader and Writer, etc. The designer draws the image which has to be printed in colour on a scale of 1:1 on screen -13- of computer -11- operating a corresponding keyboard -15- or positioning element known as a mouse -17-, as is current use. The designer may be located in the print shop or in the customer's or a contracted third party's premises, such as an advertising agency.

In the two latter cases, once the drawing is complete, it can be stored in any type of element for the storage or recording of digital data, such as a diskette, CD, DVD, etc., or printed out, a process which in any case is carried out as a colour proof. The printers may place the file with the drawing in their computer -11- either scanning it or reading it through disk reader -19- into which the diskette with the file is placed.

Whatever the circumstances may be, computer -11- has a file of image codes according to the program used. Information is extracted from the file generated and sent to a filming camera or photocomposition device -21- to sensitise photographic film. The sensitised film is loaded into an automatic developer (not illustrated) in both cases in order to obtain negative films or devices -59A-, -59A'-, -59B-, -59B'-.

As an alternative the information taken from the file in computer 11 may be sent to a printer (not illustrated) which is capable of depositing an ink capable of emulating negative photographic films -59A-, -59A'-, -59B-, -59B'-on a substrate with dimensional stability like that of a photographic film. In this case the devices such as photonegative films -59A-, -59A'-, -59B-, -59B'- are ready to be used immediately after printing.

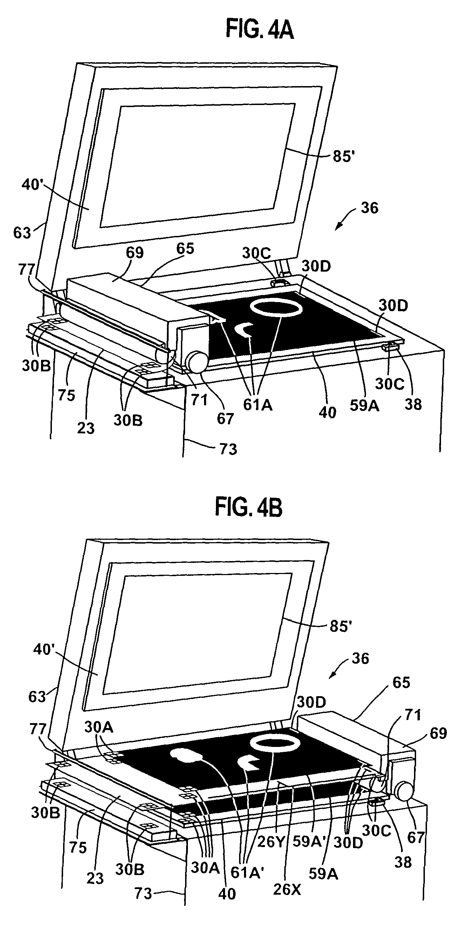

With devices such as photonegative films -59A-, -59A'-, -59B-, -59B'- two laminar printing supports -22- are manufactured from liquid resin using an irradiating machine which is adapted according to a feature of this invention described below with reference to Figure 4B in this description relating to the novel process for the manufacture of laminar supports with resin or liquid photopolymer plates. Returning to considering Figure 2, film -59A- includes real and accurate image elements -61A-corresponding to the blue colour, and the supplementary film -59A'- includes the perimeters -61A'- or outlines of those image elements -61A-, produced to manufacture a laminar support -22A- with which the images of this colour will be printed. In the same way another laminar support -22B- to print the images of black colour is manufactured using film -59B- with sub-images -61B- corresponding to the black colour and film -59B'- with its outlines -61B'-.

Using the graphics programs the image has to be deformed about a coordinate axis in relation to the other to shrink the overall drawing, for example between 2 and 8%, according to the diameter of the rollers (described below) in the longitudinal working direction Y relative to the X direction of the width of the work in order to compensate for the asymmetrical or parallax deformation due to the cylindrical surfaces of these rollers. The graphics programs include tools for this purpose which generally consist of opening a corresponding command window and altering the scale of the Y axis by the necessary percentage. This percentage may be calculated on the basis of the quotient given by the thickness of the plate and the radius of the roller.

Then using various techniques and program software tools the information in the drawing is separated by colour, generating a file for each colour, which we will call a single-colour file. Outlines -61A'- and -61B'- are generated by the software of computer -11- to generate the images for the foundation or base of the plates from the coded graphic information for elemental image elements -61A- and -61B-. The software includes parameters to establish the dimensions of outlines -61A'- and -661B'-and other aspects such as outline or geometric shapes, each base of a projecting die bearing a graphic printing element which is shaped with a perimeter exceeding the corresponding plate or projection bearing the printed graphic element by approximately 10 to 20 mm.

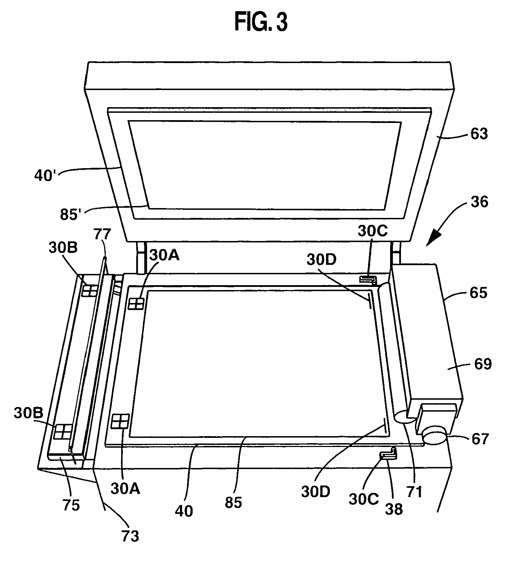

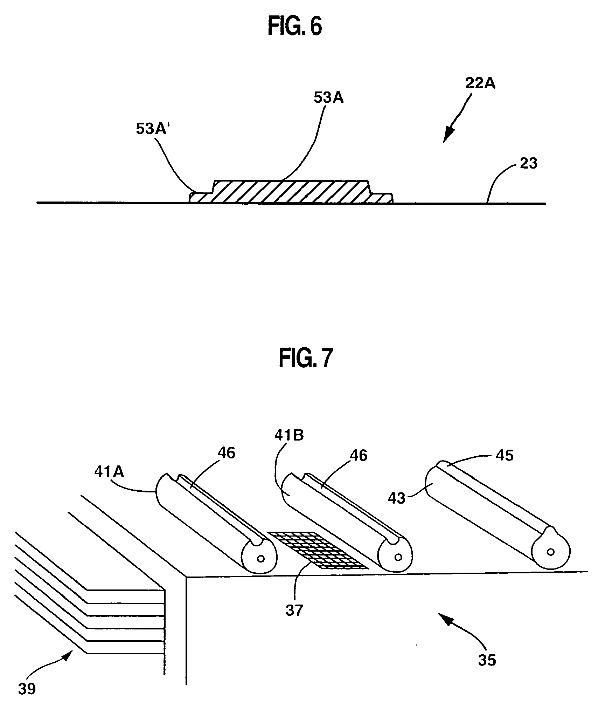

Laminar printing supports -22- may be manufactured for each colour which has to be printed sequentially, that is to say first laminar support -22A- for one colour and then -22B- corresponding to the second colour, using the adapted irradiating machine -36- as illustrated in Figure 3 to carry out the process according to this invention. Each laminar support -22- comprises a base layer or substrate -23- as illustrated in Figure 6, made of transparent polyester treated or with adhesive so that the photopolymer or liquid resin adheres to it during the irradiation process in the irradiating machine -36-mentioned. The said layer or substrate may have a thickness of between approximately 100 µm and 500 µm, especially a thickness of approximately 350 µm, with planar dimensions of approximately 2000 millimetres x 1500 millimetres. Sheets of other suitable dimensions and/or other materials may be used provided that they have dimensional stability and are transparent. Suitable sheets or substrates -23- are manufactured by a number of manufacturers in different countries throughout the world.

Through the cutting program, cutter -25- draws or engraves a transverse line -26X- on each substrate sheet -23- as an upper (or lower) margin of the drawing and another longitudinal line -26Y- bisecting the drawing, conveniently coinciding with the position of a future edge of the box passing through the middle of developed sheet -37- supplied from stack -39- as illustrated in Figure 7. Both lines -26- are drawn on each of substrate sheets -23-in precisely the same location relative to the overall drawing as illustrated in Figure 2.

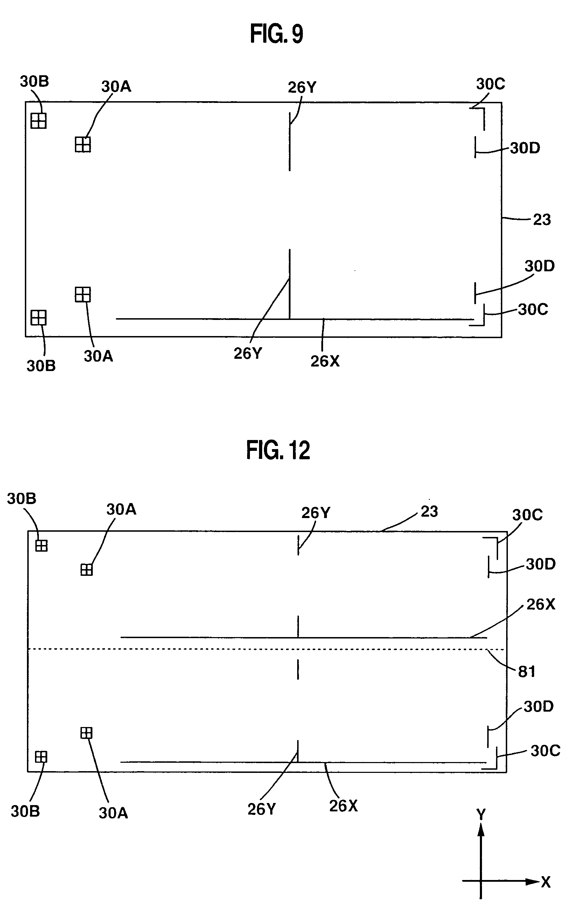

Then, in accordance with one of the features of this invention, marks -30- are printed on substrate sheet -23-which will form laminar support -22- at the same time in positions or coordinates which have been accurately predetermined in relation to axis -26-, as illustrated in Figure 9. The positions of these marks -30- are also chosen so that they can be seen at appropriate times in the process for manufacturing laminar supports -22- which will be described below.

A set of marks in the form of crosses -30B- is located close to one edge of the substrate so that substrate sheet -23- of future laminar supports -22- can be positioned in an unequivocal position on irradiating machine -36- using a complementary set of marks in the form of lines -30C- on the opposite side of substrate sheet -23- once substrate sheet -23- has been unfolded, and the latter must then be immobilised in the precise positions determined by marks -30-.

Figure 3 illustrates an irradiating machine -36- adapted for manufacturing laminar printing supports according to this invention. The conventional part of machine -36-comprises a frame -73- which contains an illuminating device (not shown) which irradiates upwards through a flat horizontal glass -40- with its corresponding window area -85- which acts as a base for a working space for the manufacture of laminar support -22-. Over this lower window -40- there runs a carriage -65- which can be adjusted for height with respect to glass -40- which contains a container -69- for a curable liquid (a polymerisable substance such as resin) together with a laminating roller -71- which can be adjusted for height with respect to glass -40-. A cover -63- contains a second illuminating device (not shown) which irradiates downwards through the area of window 85' with respect to upper glass -40'-. Supporting members (not shown) for upper glass -40'- are present or are fitted between the two glasses -40-, these members making it possible to adjust the distance or space between the two glasses -40-, the adjustment of said distance making possible to obtain the desired thickness when manufacturing the plate(s), with dies projecting from their corresponding bases or mounts backing onto or adhering to the dimensionally stable base substrate sheet of laminar supports -22-.

The set of marks -30B- and -30C on substrate sheets -23-ensures that these substrate sheets -23A-, -23B-corresponding to different colours are each in turn precisely in the same position over glass -40- of irradiating machine -36- which has been adapted according to this invention with the same marks -30B- at the start of the working travel of its carriage -65-, as well as marks -30C- on the other side. Provision is also made for a third set of marks in the form of crosses -30A- on the lower glass -40- of machine -36-, which may be in positions in line with or slightly more inward with respect to marks -30B- in such a way that they are visible when carriage -65- is in its resting position on the side opposite that where it starts work, as illustrated in Figure 3.

These marks -30A- have their corresponding marks on the films of negative -59- like the other set of complementary marks -30D- in the form of lines, and on substrate sheet -23-. By placing marks -30A- in register on the glass and the negatives it is ensured that the negatives are in the precise positions with respect to glass -40- and ultimately that substrate sheet -23- is precisely positioned with future laminar supports -22-. The third marks -30A- on substrate sheet -23- are used to position the outline film -59'- as illustrated in Figure 4B.

In addition to marks -30- mentioned, at the same time during the stage of the marked printing or embossing of substrate sheets -23- with cutter -25- the reference axes for subsequent fitting and positioning are also printed, thus forming the said roller of the printing machine, comprising longitudinal line -26Y- and transverse line -26X- as illustrated in Figure 2.

Up to now what has been described can be regarded as the preparatory stage for the manufacturing process, and an explanation will now be provided of the stage of production proper, beginning with negatives -59A-, -59A'-prepared for the laminar support for the first colour. As the laminar support for the second and subsequent colours will be made subsequently in the same way in the same irradiating machine, but using corresponding negatives -59B-, -59B'-, hence the importance of marks -30- intended to ensure that the first and second laminar supports are manufactured with their colours in register when they are fitted and positioned on their respective rollers during the process of printing the corrugated substrates.

In order to obtain laminar supports manufactured in a sequential manner on lower glass -40- of irradiating machine -36- in Figure 3, negative -59A- is first spread out as illustrated in Figure 4A, and contains the die shapes -61A- for the various elements of the image corresponding to the colour in question, in this case blue. A plastic separating film (not shown) is then placed over this negative -59A- solely for the purpose of not soiling negative -59A- with the resin which is subsequently poured during a passage of carriage -65-.

Passage of the carriage at the same time or subsequently unrolls substrate sheet -23- on the resin contained and supported by lower glass -40- of the machine, this double operation of carriage -65- being subsequently started as follows:

Carriage -65- contains a container for liquid resin -69-and a receptacle -67- in which the sheet for substrate -23- is held rolled-up. Carriage -65- is brought to the starting end of its working travel, which is positioned close to marks -30B-. An edge of rolled substrate sheet -23- is pulled out to expose preprinted marks -30B- and it is positioned making these marks -30B- coincide with matching marks -30B- which are engraved or marked on a shelf -75- adhering or fixed to frame -73- of machine -36-. The edge of sheet -23- is located in this position, for example using adhesive tape or a vacuum system, together with a for example mechanically or pneumatically operated securing means -77- to ensure that substrate sheet -23- is securely fixed. The travel of carriage -65-starts again, and as it advances it pours resin onto the film covering negative -59A- (this film being stretched by the vacuum process which is produced through lower glass, -40- and is therefore wholly flat, copying the flatness of the said lower glass and negative -59A-), at the same time or subsequently rolling out substrate sheet -23- through the use of laminating roller -71- onto the poured resin, the latter being retained in liquid form within a kind of "tray" formed laterally by straight side walls or bars (not shown) located along the sides of the lower radiating plate and below by the same radiating plate -40- of the machine.

When carriage -65- reaches the end of its travel as illustrated in Figure 4B, the precise positioning of substrate sheet -23- can be checked using the remaining marks -30A- and -30C-. These must be secured above their matching marks -30C- which are marked and/or engraved on fixing device -38-. Negative -59A'- which contains outline shapes -61A'- is then placed on substrate sheet -23- using marks -30A- and -30D- to position it precisely.

As mentioned in the previous paragraph, with substrate sheet -23- fixed or supported, cover -63- of the machine is then lowered, and when this is in its end of the stroke or closed position after a predetermined interval of a few seconds wait a vacuum process is started which is carried out through upper glass -40'- so that in this way said substrate sheet -23- becomes wholly flat thus copying the flatness of the said upper glass and the irradiation stage, this comprising lighting the ultraviolet lamps located above glass -40'- for a predetermined time of a few seconds, sufficient to irradiate the liquid resin selectively through negative -59A'- to solidify it with the outline shapes -61A'- of the image elements on the plate to a specified depth to define the base or foundation mount of each plate adhering to substrate sheet -23-. They are then switched off and the ultraviolet lamps located below glass -40- are switched on for a predetermined time of a few seconds sufficient for selective irradiation, this time through lower negative -59A-, and thus the resin is solidified with shapes -61A-of the image elements of the plate joined to its resin bases or mounts. The lamps or tubes generating ultraviolet light located above glass -40'- and those located below glass -40- can be switched on at the same time for a predetermined time of a few seconds, producing the same effect and achieving the same objective as those mentioned in the previous paragraph.

Laminar support -22- manufactured in this way is removed from irradiating machine -36-. It is then passed to equipment of known use for draining off the resin and/or a machine with an air blower in which even more unsolidified liquid resin is recovered, and then subsequently passed to a washing machine, to another for final hardening of the base or mount, to a drying machine, and finally to another to ultimately remove any tackiness which might remain (neither the equipment for drainage nor the other machines mentioned are illustrated as they are all of known use).

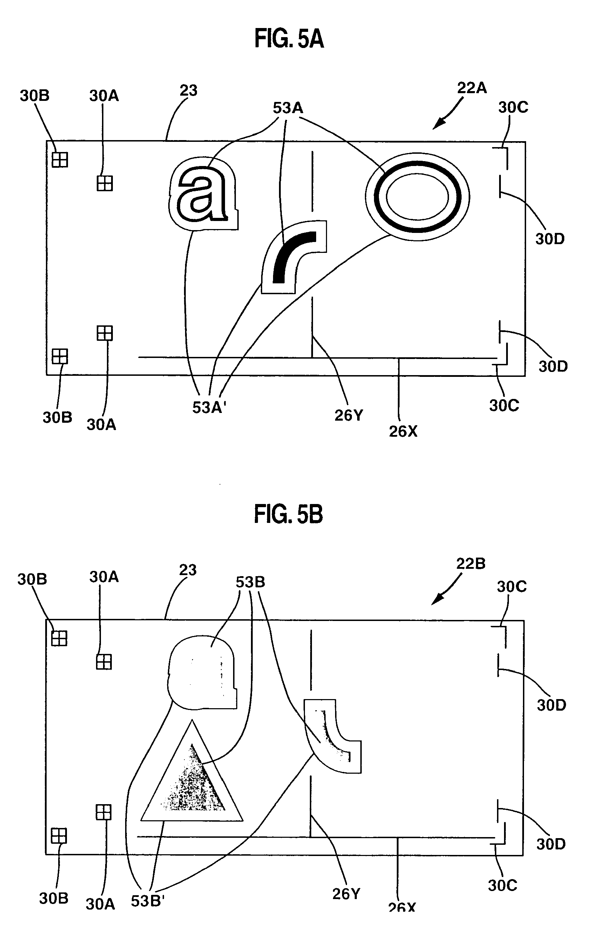

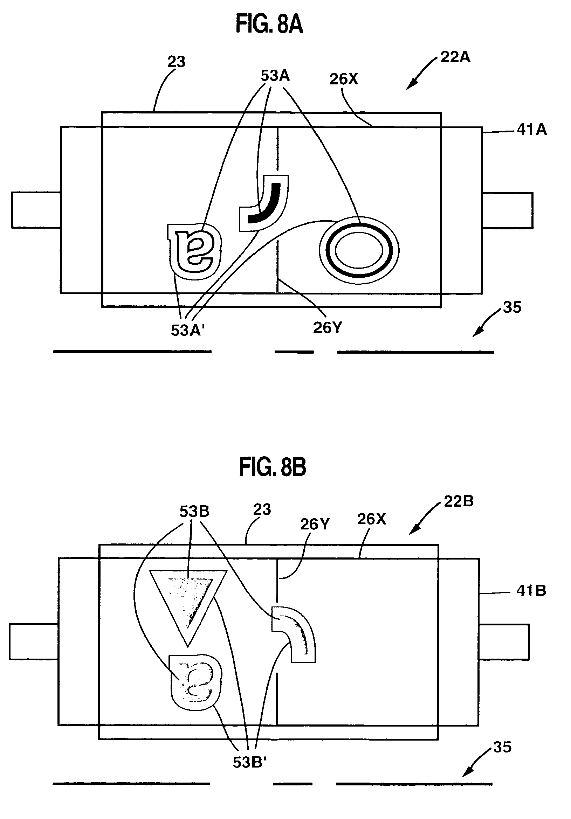

After the laminar support has passed through this sequence of machines, laminar support -22- obtained is ready for printing. One or more matching laminate supports are then manufactured sequentially depending upon the number of colours which have to be printed, using the same process with corresponding negatives -59B- and -59B'-. Figures 5A, 5B illustrate two laminar supports -22A- and -22B-manufactured successively using this process, one for the blue colour with its plates -53A- and its corresponding bases or mounts -53A'-, the other for the black with its plates -53B- and its corresponding bases or mounts -53B'-, in a condition to be directly fitted onto corresponding rollers -41- of printing machine -35- in order to bring about printing of these multicoloured images on sheet -37-. Said rollers -41- precede a final roller -43-equipped with knives -45- for embossing cardboard sheet -37- with the future edges which will define the folds between the sides of the boxes illustrated diagrammatically in Figure 7, using marks -46- on rollers -41- and lines -26- on substrate sheets -23- of laminar supports -22- so that image elements -53- are in register with the required accuracy as illustrated in Figures 8A and 8B. The illustrated cross-section in Figure 6 shows substrate sheet -23-, an image element -53A- and a base or mount -53A'- comprising laminar support -22A-.

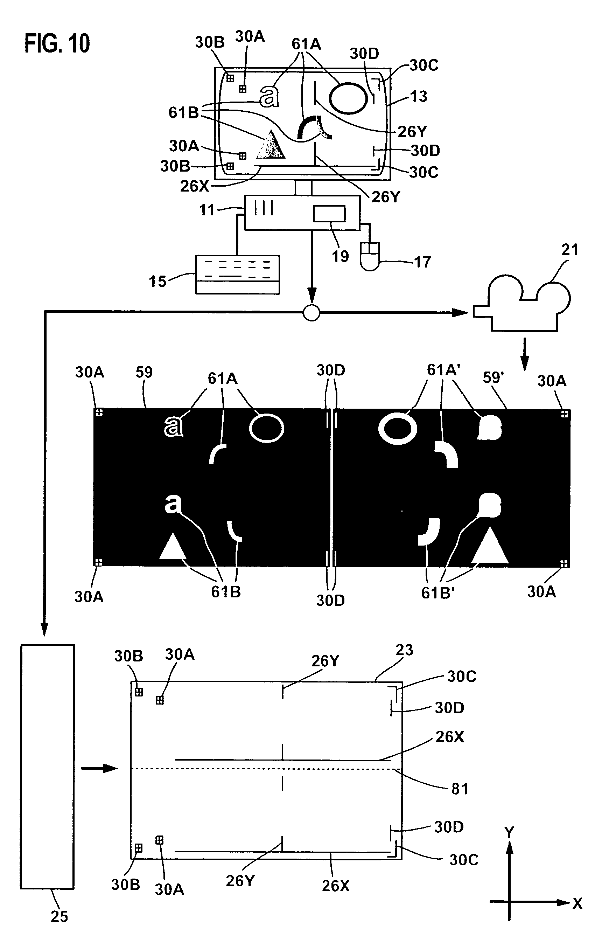

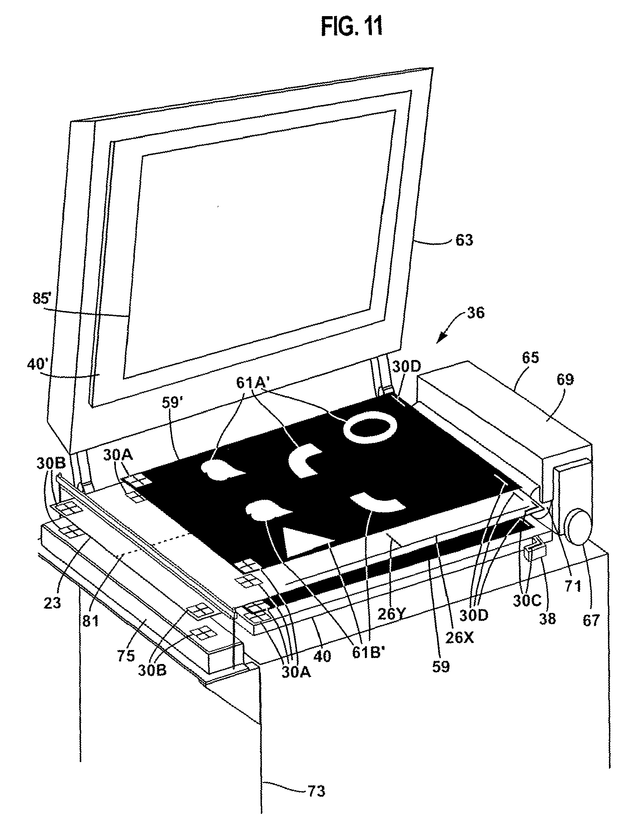

Depending upon the dimensions of window areas -85- of glass -40- and -85'- of glass -40'- of irradiating machine -36- modified as illustrated in Figure 3, a set of laminar supports -22A- and -22B- for different colours can be manufactured sequentially, and/or at the same time or simultaneously in a single manufacturing process using the same irradiating machine -36-, Figure 4B illustrating the process for manufacturing a laminar support -22-sequentially, in this case illustrating the manufacture of a future laminar support -22A- which is reproduced in Figure 11 with the materials or devices -23-, -59-specific to the simultaneous process. The simultaneous process follows steps similar to the sequential process, except for the differences mentioned below and illustrated in Figures 10, 11, 12, 13 and 14.

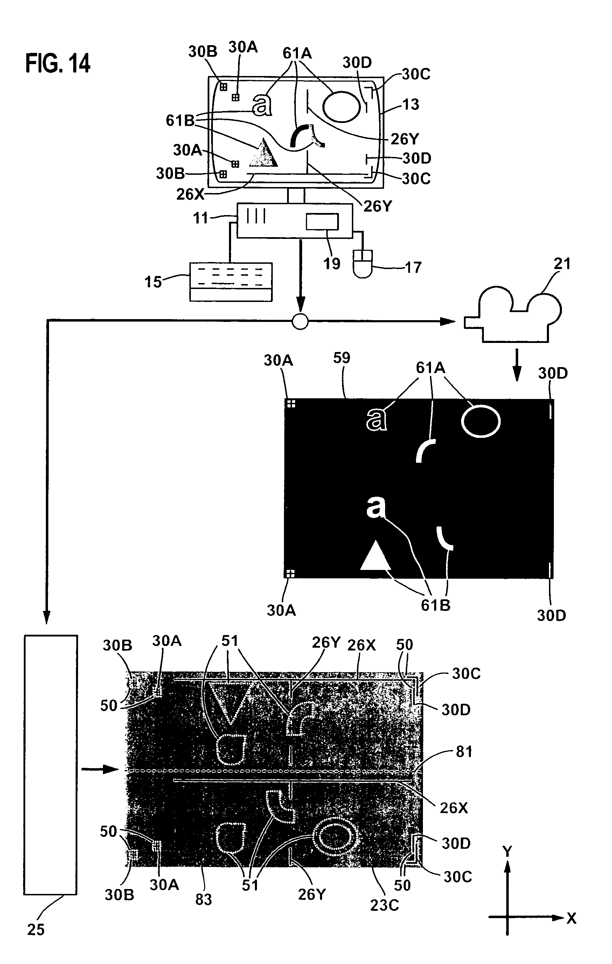

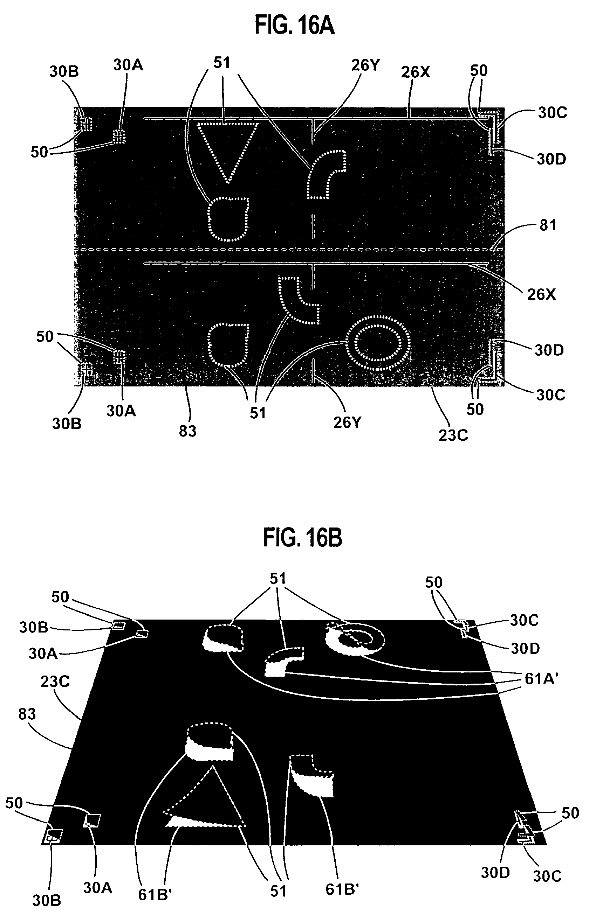

Cutter -25- draws or engraves transverse lines -26X- as an upper or lower margin of the drawing and a longitudinal line -26Y- passing through the middle on sheet or substrate -23- forming the only base of composite laminar support -22-, between the two sets of images representing one colour, as indicators of overall positioning, and as many cutting lines -81- for the separation of each laminar support as are necessary, as illustrated in Figures 10 and 14. At the same time marks -30- are printed on substrate sheet -23- in positions or coordinates which have been accurately predetermined in relation to axis -26-, as illustrated in Figures 12 and 16A.

Image elements -61A- and -61B- are in turn printed on photonegative film -59- forming sets side by side, and in the same way outline elements -61A'- and -61B'- are printed on photonegative film -59'-. The same cycle as described previously is then carried out this time to produce laminar support -22- with substrate sheet -23- and films -59- and 59'-.

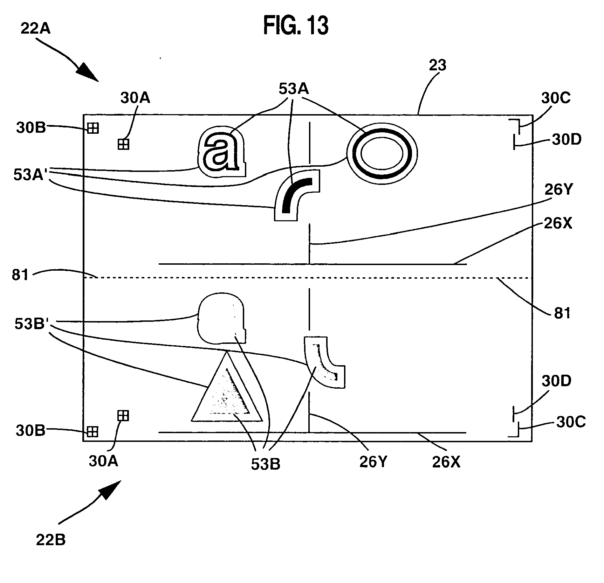

Using multiple negative -59- for the manufacture of laminar supports simultaneously, this results in a single process of manufacture as illustrated in Figure 11, obtaining the laminar support for the blue colour and the black colour at the same time with their image elements -53A- and their corresponding bases or mounts -53A'- and -53B- and their corresponding bases or mounts -53B'- as illustrated in Figure 13.

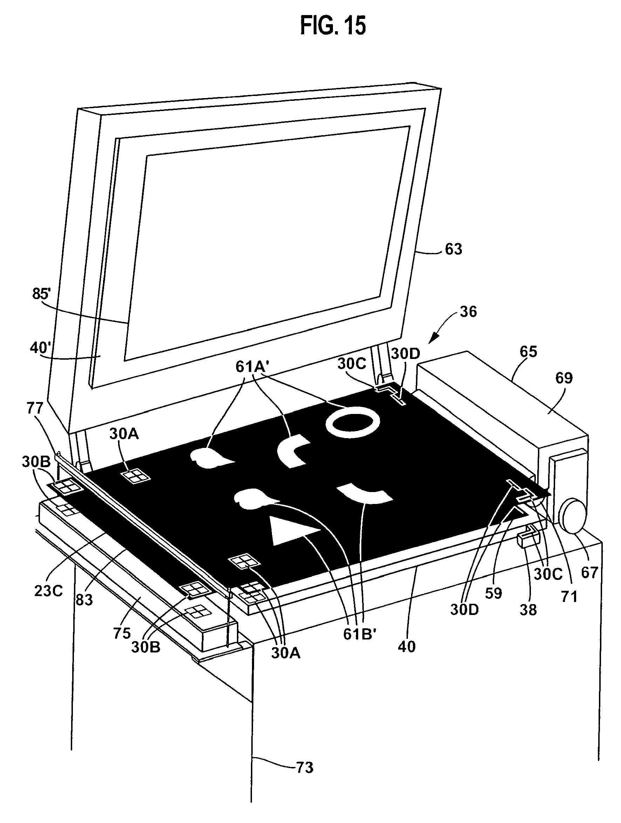

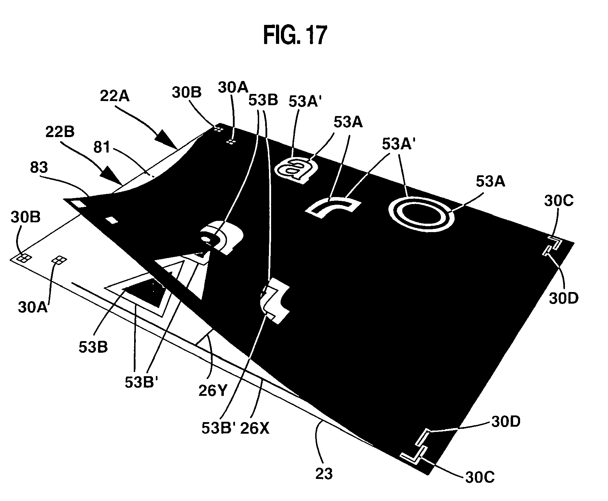

Use of the outline photonegative film -59A'- or -59'- in the previous embodiments can be dispensed with. Using a composite transparent substrate sheet -23C- having the same dimensional stability characteristics for adhesion or treatment for adhesion of the liquid photopolymer or resin as substrate sheet -23- instead of substrate sheet -23- as a substrate having dimensional stability, this substrate sheet -23C- having a laminate -83- on the side opposite that of the adhesive or treatment mentioned, as illustrated in Figures 14 and 15. Laminate -83- may be paper, vinyl or other material which blocks the passage of ultraviolet light as illustrated in Figures 16A, 16B and 17, thus acting as a base for laminar supports -22- and furthermore as a device for restricting the passage of ultraviolet light.

This blocking laminated member -83- must be cut to a predetermined depth with shapes -50- and -51- illustrated in Figure 16B, using cutter -25- for this process as illustrated in Figure 14. Cut-outs -50- must be removed so that marks -30- and cuts -15- can be seen so that outline shapes -61A'- and -61B'- corresponding to images -61A- and -61B- can be seen, thus revealing the transparency of composite substrate sheet -23C- for the passage of ultraviolet light to form foundations or bases -53A'- and -53B'- as illustrated in Figure 17.

Through this composite substrate sheet -23C- with its blocking laminate -83- as illustrated in Figure 15, the use of restrictor devices, such as photonegative films -59A'- and -59B'- or -59'- is also dispensed with.

In addition to mentioned marks -30-, cutter -25- prints or cuts longitudinal lines -26Y- and transverse lines -26X-for subsequent fitting to a roller at the same time during the stage of printing substrate sheet -23C-, as illustrated in Figure 16A, this being displayed in mirror-image or reflected form in relation to photonegative film -59- so that said marks -26- and -30-can be seen (because illustrating the said substrate sheet -23C- from the side of laminate element -83- would not make it possible to see the marking or engraving of marks -26-, it would only be possible to see marks -30-, removing cut-outs -50-, as said substrate sheet -23C- is illustrated in Figures 15 and 16B).

After the process of irradiation in machine -36- laminate element -83- blocking ultraviolet light must also be completely removed from substrate layer -23C-, as illustrated in Figure 17, before laminar support -22- is placed in or passed to the drainage equipment, then undergoing all the steps through the various devices and/or machines of known use mentioned in the preceding paragraphs. After having removed the blocking member -83-, the substrate sheet -23C- is conformed to have characteristics identical to those of substrate sheet -23-, these sheets mentioned, substrate sheet -23- the single base for laminar supports -22-.

In the embodiments described printed boxes with different multicolour images are obtained with excellent register between the various colours and image elements, requiring a time for production of the laminar supports which is significantly less than that in prior known procedures and saving enormous time and disadvantages in the fitting thereof.

## Claims

1. A process for the manufacture of rollers for the printing of laminar materials of a type comprising a cylindrical core of the roller with a surrounding laminar support bearing individual printing plates in relief,
**characterised by** the following successive operational stages:
- positioning a laminar element having a negative structure or a structure restricting the passage of light in particular areas corresponding to the full extent of the surface of a printing cylinder on a flat radiating base, each of the areas of the negative permitting the passage of radiation corresponding to the external profile of one of the dies of the laminar printing support of the printing roller,
- surface protection of the upper surface of the negative laminar element through a transparent sheet of protective material,
- covering the entire surface of the protective negative with the protecting film through a layer of a material which can be cured through the action of radiation from the radiating plate,
- fitting a transparent laminar element acting as a dimensionally stable laminar substrate designed to constitute the base of the laminar printing support which can be applied to the printing roller,
- placing above the substrate sheet element a second laminar element acting as a negative with multiple areas permitting the passage of radiation for curing of the layer of curable material in such a way that its relative positioning corresponds to the same areas which permit the passage of radiation in the first negative, but having a larger surface area than the latter,
- placing a flat upper plate emitting radiation curing the layer of curable material,
- emitting curing radiation for a predetermined time from one of the two radiating plates,
- emitting curing radiation for a predetermined time from the second radiating plate,
- withdrawing the printing support formed by the laminar substrate element with the printing relief elements resulting from the stages of curing by radiation, and
- recovering surplus resin from the printing support.

2. A process for the manufacture of rollers for the printing of laminar materials according to claim 1,
**characterised in that** the laminar element comprising the substrate bearing the printing relief is equipped on the side coinciding with the resin with a finish designed to encourage adhesion of the resin to the said substrate.

3. A process for the manufacture of rollers for the printing of laminar materials according to claim 1,
**characterised by** the application of vacuum through both radiating plates to encourage intimate contact with the negative laminar elements, the dimensionally stable laminar substrate and the protective sheet with the said radiating plates without wrinkles or irregularities.

4. A process for the manufacture of rollers for the printing of laminar materials according to claim 1,
**characterised in that** centering marks are provided on the edges of the negative laminar elements and the substrate intended to support the printing relief comprising the printing supports, these marks making it possible to cause the said elements to coincide with each other vertically and with fixed marks directly or indirectly associated with the radiating plates.

5. A process for the manufacture of rollers for the printing of laminar materials according to claim 1,
**characterised in that** one of the laminar elements acting as a negative has areas for the passage of radiation for selective curing of curable material in regions corresponding to image elements, while the other negative element has areas permitting the passage of radiation whose shape corresponds to bases with the outline of each respective image element.

6. A process for the manufacture of rollers for the printing of laminar materials according to claim 1,
**characterised in that** the curable material is of polymerisable material, preferably a liquid resin.

7. A process for the manufacture of rollers for the printing of laminar materials according to claim 1,
**characterised in that** the radiating plates are the glass plates of a machine having radiating plates opposing each other.

8. A process for the manufacture of rollers for the printing of laminar materials according to claim 1,
**characterised in that** the dimensionally stable transparent substrate intended to support the printing relief of the printing roller is applied onto the layer of curable material by unrolling from a roll carrying the same which is moved over the upper surface of the layer of curable material.

9. A process of manufacture according to claim 1,
**characterised in that** the said marks or centering indicators comprise marks on the side of or ahead of the radiating plate, which include a first set (30B) close to one extremity where the carriage rests before pouring the resin and unrolling the sheet and a second set of marks (30A) further inward on the said glass from where the said carriage rests.

10. A process of manufacture according to claim 9,
**characterised in that** the said marks include a third set of marks (30C-30D) close to the end opposite to that where the said carriage rests after pouring the resin and unrolling the dimensionally stable transparent substrate sheet.

11. A process of manufacture according to any one of claims 5 to 10, **characterised in that** the said restrictor devices comprise filter films (59-59') with transparent areas (61, 61') which allow radiation to pass, one (61) having the shape of at least one image element which has to be reproduced in the corresponding colour and the other having that of an outline (61') defining the base of the image element.

12. A process of manufacture according to claim 11,
**characterised in that** the said filter devices comprise two films in which positioning marks matching those on the machine are incorporated identical to and in register with those of the dimensionally stable transparent substrate sheet, using the said marks and the machine marks and those on the dimensionally stable transparent substrate sheet to position films, one above the bottom window and the other adhering to or below the cover window, in precise vertical register with each other and with the dimensionally stable transparent substrate sheet.

13. A process of manufacture according to claim 12,
**characterised in that** the said filter devices comprise a first film which incorporates positioning marks matching those of the machine identical to and in register with those of the dimensionally stable transparent substrate sheet, and a second film laminated to the substrate sheet or forming it and provided with elements for filtering the illumination from the radiating media according to the said outlines, using the said marks of the first film, those on the machine and those of the dimensionally stable transparent substrate sheet to position the first film on the lower radiating plate.

14. A process of manufacture according to claims 11, 12 or 13, **characterised in that** the said sheets with the areas allowing light to pass selectively are formed of corresponding photonegative films.

15. A process of manufacture according to claim 1,
**characterised in that** a first of the photonegative films has at least one image element which has to be reproduced in the corresponding colour while the other photonegative film has at least one figure whose perimeter encloses and defines a base of at least one such image element of the first film and **in that** positioning marks are located on both photonegative films which can be used to place them in vertical register with one another and with the dimensionally stable sheet.

16. A process of manufacture according to claim 15,
**characterised in that** the said marks are located outside the area of the said image which has to be printed.

17. A process of manufacture according to either of claims 15 or 16, **characterised in that** the said marks comprise at least a first pair of marks (30A) on opposite sides of each photonegative film.

18. A process of manufacture according to claim 17,
**characterised in that** the said marks comprise a second pair of marks (30D) on opposite sides of each photonegative film and displaced with respect to the first marks at opposite extremities.

19. A process of manufacture according to any one of claims 15, 16, 17 or 18, **characterised in that** the said remaining photonegative film forms a laminate (83) over a dimensionally stable substrate sheet to form a substrate for a laminar printing support.

20. A process of manufacture according to claim 1,
**characterised in that** the substrate to form the printing support comprises second printed or engraved positioning marks (30) which can be used to place it in vertical register with the photonegative films (59A-59A') and with at least one dimensionally stable substrate layer (23A) to form the laminar support (22A), and at least another substrate (23B) to form the laminar support (22B) corresponding to the other colour.

21. A process of manufacture according to claim 20,
**characterised in that** the said marks comprise at least a first pair of marks (30B) on opposite sides of the sheet to position the said sheet on the radiating machine used for the said process of manufacture.

22. A process of manufacture according to claim 21,
**characterised in that** the said marks comprise a second pair of marks (30A) on opposite sides of the substrate sheet and displaced with respect to the first marks, which can be used to place them in vertical register with the restrictive films used for the process of manufacture according to claim 11.

23. A process of manufacture according to claim 22,
**characterised in that** the said marks comprise a third pair of marks (30D) on opposite sides of the substrate sheet displaced with respect to the first marks at opposite extremities, which can be used to place them in vertical register with the said restrictive films.

24. A process of manufacture according to claim 23,
**characterised in that** the said marks comprise a fourth pair of marks (30C) on opposite sides of the sheet displaced with respect to the first marks at opposite extremities to position the said sheet on the radiating machine used for the said process of manufacture.

25. A process of manufacture according to any one of claims 22, 23 or 24, **characterised in that** it includes a sheet (83) with marks (30) which can be cut off (50) on one of its faces.

26. A process of manufacture according to claim 14,
**characterised in that** the said marks are formed in the pair of photonegative films during the same process in which the corresponding image elements or figures whose outlines surround the image elements are formed and in the dimensionally stable transparent substrate sheet at the same time as additional marks (26) for overall positioning on a roller (41) of the printing machine (35) are printed or engraved.

27. A process of manufacture according to claim 26,
**characterised in that** the said marks are formed in the photonegative films with a filming camera controlled by a computer program.

28. A process of manufacture according to claim 1,
**characterised in that** the said areas which allow light to pass selectively are formed by corresponding cut-outs (51) made in the said films.

29. A process of manufacture according to claim 28,
**characterised in that** the said cut-outs are made by means of a machine controlled by a computer program.

30. A process of manufacture according to claim 1,
**characterised in that** the stages of placing the dimensionally stable transparent substrate sheet and applying the second restrictive device above the same are carried out sequentially **in that** order.

31. A process of manufacture according to claim 1,
**characterised in that** irradiation is first performed through the restrictor device containing the outline figures defining the bases and then through the restrictor device containing the image elements.

32. A process of manufacture according to claim 1,
**characterised in that** irradiation is carried out simultaneously through the two radiating plates to cure the resin in regions corresponding to the said respective image and base elements.

33. A process of manufacture according to claim 1,
**characterised in that** at least two laminar printing supports corresponding to different colours or images are manufactured simultaneously on the same substrate sheet, locating the corresponding image elements, the outlines corresponding to each laminar printing support being placed side by side on the two compound restrictor devices in such a way as to cut the dimensionally stable transparent substrate sheet with the plate members formed thereon in the corresponding laminar printing supports.

34. A process of manufacture according to claim 1,
**characterised in that** the dimensionally stable transparent substrate sheet and the restrictor devices are immobilised in the marked positions by fixing a first end of the dimensionally stable transparent substrate sheet in position and then securing all the said dimensionally stable transparent substrate sheet with complete securing means.

35. A process of manufacture according to claim 34,
**characterised in that** the said end of dimensionally stable transparent substrate sheet is attached by applying adhesive tape or vacuum and that all the substrate sheet is then secured using mechanically or pneumatically operated securing means.

36. An irradiating machine for carrying out the process according to claims 1 to 24 to manufacture laminar printing supports, each of which comprises at least one plate representative of a single-colour portion of an image which has to be printed on laminar materials, adhering to the dimensionally stable laminar substrate in a specific position for the said image which has to be printed, each plate comprising a base from which there projects a die shaped with the said single-colour portion of the image, the said irradiating machine comprising:
a frame fitted with a lower window beneath which a lower radiating device is located,
a cover provided with an upper window above which an upper radiating device is located,
means for the injection of fluid material which can be set by radiation into the space between the two glasses,
a device for unrolling a dimensionally stable substrate sheet onto the said glass,
a first retaining device to secure to said lower glass on the said lower radiating device, a first filter film printed with lines corresponding to the single-colour portions of the said image which has to be printed, and
a second retaining device to secure to the said upper glass below the upper radiating device, a second filter film printed with outline figures corresponding to the said single-colour portions printed in the said first filter film and
**characterised in that** the said irradiating machine is marked like the two filter films with overall positioning marks which are distributed horizontally and can be used to place the dimensionally stable substrate sheet and the two vertical films in vertical register with each other in such a way that the said machine is capable of manufacturing a complete laminar printing support in a process of manufacture according to any one of the preceding claims.

37. An irradiating machine according to claim 36,
**characterised in that** the said marks comprise marks alongside the said glass which include a first set close to one extremity where the carriage rests before pouring the resin and unrolling the sheet and a second set of marks further inward on the said glass from where the said carriage rests.

38. A radiating machine according to claim 37,
**characterised in that** the said marks include a first set of marks close to the extremity opposite that where the said carriage rests after pouring the resin and unrolling the sheet.

39. An irradiating machine according to claims 25, 26 or 27, **characterised in that** it comprises vacuum retaining means capable of immobilising the said photonegative films against the corresponding transparent glasses of the base and cover of the irradiating machine.

40. A printing support for rollers for the printing of laminar materials manufactured according to claims 1 to 25, **characterised in that** it comprises a transparent dimensionally stable laminar support, one of the faces of which is intended to coincide exactly with the external surface of the cylindrical core of a printing roller, fixed marks on the support coinciding with fixed marks on the roller, while the other surface has printing relief members each of which is formed by a base of little height from which there extends in dimensionally adjusted form the body bearing the graphic image or die, the thickness of the laminar support being between 200 µm and 500 µm.

41. A printing support according to claim 40,
**characterised in that** it comprises a polyester laminar support.

42. A support according to claim 41, **characterised in that** the thickness of the laminar support is approximately 350 µm.

43. A support according to claim 40, **characterised in that** each base of a projecting die bearing the graphic image being printed comprises an outline which exceeds the corresponding die or projection bearing the graphic printing image by approximately 10 to 20 mm.

## Amended claims

### Amended claims under Art. 19.1 PCT

**1.** A process for the manufacture of a surrounding laminar support bearing embossed individual printing dies or plates for subsequent fitting around the cylindrical core of a roller for the printing of laminar materials, comprising the following successive operational stages:
- positioning a laminar element having a negative structure or a structure restricting the passage of light in particular areas corresponding to the full extent of the surround for the printing roller on a flat irradiating base, each of the areas of the negative permitting the passage of radiation corresponding to the external profile of one of the dies of the laminar printing support of the printing roller,
- covering the entire surface of the negative with a layer of a material which can be cured through the action of radiation from the radiating plate,
- fitting a transparent laminar element acting as a dimensionally stable laminar substrate designed to constitute the base of the laminar printing support which can be applied to the printing roller,
- placing above the substrate sheet element a second laminar element acting as a negative or restricting the passage of light with multiple areas permitting the passage of radiation for curing of the layer of curable material in such a way that its relative positioning corresponds to the same areas which permit the passage of radiation in the first negative, but having a larger surface area than the latter,
- placing a flat upper plate emitting radiation curing the layer of curable material,
- emitting curing radiation for a predetermined time from one of the two radiating plates, and
- emitting curing radiation for a predetermined time from the second radiating plate,
**characterised by** the prior provision of guide marks on the laminar transparent element acting as a substrate which enable the latter to be accurately positioned on the roller and centering marks following a fixed pattern at the edges of the fixed laminar elements and the transparent laminar element acting as substrate outside the area of the said image which has to be printed, with the result that the said elements coincide with each other vertically, the areas of the two negative laminar elements which allow the passage of radiation being positioned in relation to the latter marks in such a way that the dies when fitted are accurately located in the required positions relative to the guides on the printing roller.

**2.** A process of manufacture according to claim 1,
**characterised in that** the laminar element comprising the substrate bearing the embossed printing is equipped on the side coinciding with the resin with a finish designed to encourage adhesion of the resin to the said substrate.

**3.** A process of manufacture according to claim 1,
**characterised by** the application of vacuum through both radiating plates to encourage intimate contact without wrinkles or irregularities between the negative laminar elements and the dimensionally stable laminar substrate.

**4.** A process of manufacture according to claim 1,
**characterised in that** fixed marks directly or indirectly associated with the radiating plates are provided.

**5.** A process of manufacture according to claim 1,
**characterised in that** one of the laminar elements acting as a negative has areas for the passage of radiation for selective curing of curable material in regions corresponding to image elements, while the other negative element has areas permitting the passage of radiation whose shape corresponds to bases with the outline of each respective image element.

**6.** A process of manufacture according to claim 1,
**characterised in that** the curable material is a polymerisable material, preferably a liquid resin.

**7.** A process of manufacture according to claim 1,
**characterised in that** the radiating plates are the glass plates of a machine having radiating plates opposing each other.

**8.** A process of manufacture according to claim 1,
**characterised in that** the dimensionally stable transparent substrate intended to support the embossed printing of the printing roller is applied onto the layer of curable material by unrolling from a roll carrying the same which is moved over the upper surface of the layer of curable material.

**9.** A process of manufacture according to claim 1,
**characterised in that** the said marks or centering indicators comprise marks on the side of or beyond the radiating plate, which include a first set (30B) close to one extremity where the carriage rests before pouring the resin and unrolling the sheet and a second set of marks (30A) further inward on the said glass from where the said carriage rests.

**10.** A process of manufacture according to claim 9,
**characterised in that** the said marks include a third set of marks (30C-30D) close to the end opposite to that where the said carriage rests after pouring the resin and unrolling the dimensionally stable transparent substrate sheet.

**11.** A process of manufacture according to any one of claims 5 to 10, **characterised in that** the said restrictor devices comprise filter films (59-59') with transparent areas (61, 61') which allow radiation to pass, one (61) having the shape of at least one image element which has to be reproduced in the corresponding colour and the other having that of an outline (61') defining the base of the image element.

**12.** A process of manufacture according to claim 11,
**characterised in that** the said filter devices comprise two films in which positioning marks matching those on the machine are incorporated identical to and in register with those of the dimensionally stable transparent substrate sheet, using the said marks and the machine marks and those on the dimensionally stable transparent substrate sheet to position films, one above the bottom window and the other adhering to or below the cover window, in precise vertical register with each other and with the dimensionally stable transparent substrate sheet.

**13.** A process of manufacture according to claim 12,
**characterised in that** the said filter devices comprise a first film which incorporates positioning marks matching those of the machine identical to and in register with those of the dimensionally stable transparent substrate sheet, and a second film laminated to the substrate sheet or forming it and provided with elements for filtering the illumination from the radiating media according to the said outlines, using the said marks of the first film, those on the machine and those of the dimensionally stable transparent substrate sheet to position the first film on the lower radiating plate.

**14.** A process of manufacture according to claims 11, 12 or 13, **characterised in that** the said sheets with the areas allowing light to pass selectively are formed of corresponding photonegative films.

**15.** A process of manufacture according to claim 1,
**characterised in that** a first of the photonegative films has at least one image element which has to be reproduced in the corresponding colour while the other photonegative film has at least one figure whose perimeter encloses and defines a base of at least one such image element of the first film and **in that** the positions of the said guide marks and centering marks on the transparent laminar substrate in a predetermined positional relationship with positioning guides on the roller and positioning marks located on both photonegative films respectively, correlating all the marks by means of a computer, in the memory of which a template corresponding to the printing roller has been stored, used to mark the indicators on the transparent laminar substrate and the marks on the photonegative films.

**16.** A process of manufacture according to claim 1,
**characterised in that** a single transparent laminar element is positioned depending on the dimensionally stable laminar substrate intended to form the base of the laminar printing support which can be applied to the printing roller.

**17.** A process of manufacture according to either of claims 15 or 16, **characterised in that** the said marks comprise at least a first pair of marks (30A) on opposite sides of each photonegative film.

**18.** A process of manufacture according to claim 17,
**characterised in that** the said marks comprise a second pair of marks (30D) on opposite sides of each photonegative film and displaced with respect to the first marks at opposite extremities.

**19.** A process of manufacture according to any one of claims 15, 16, 17 or 18, **characterised in that** the said remaining photonegative film forms a laminate (83) over a dimensionally stable substrate sheet to form a substrate for a laminar printing support.

**20.** A process of manufacture according to claim 1,
**characterised in that** the substrate to form the printing support comprises second printed or engraved positioning marks (30) which can be used to place it in vertical register with the photonegative films (59A-59A') and with at least one dimensionally stable substrate layer (23A) to form the laminar support (22A), and at least another substrate (23B) to form the laminar support (22B) corresponding to the other colour.

**21.** A process of manufacture according to claim 20,
**characterised in that** the said marks comprise at least a first pair of marks (30B) on opposite sides of the sheet to position the said sheet on the radiating machine used for the said process of manufacture.

**22.** A process of manufacture according to claim 21,
**characterised in that** the said marks comprise a second pair of marks (30A) on opposite sides of the substrate sheet and displaced with respect to the first marks, which can be used to place them in vertical register with the restrictive films used for the process of manufacture according to claim 11.

**23.** A process of manufacture according to claim 22,
**characterised in that** the said marks comprise a third pair of marks (30D) on opposite sides of the substrate sheet displaced with respect to the first marks at opposite extremities, which can be used to place them in vertical register with the said restrictive films.

**24.** A process of manufacture according to claim 23,
**characterised in that** the said marks comprise a fourth pair of marks (30C) on opposite sides of the sheet displaced with respect to the first marks at opposite extremities to position the said sheet on the radiating machine used for the said process of manufacture.

**25.** A process of manufacture according to any one of claims 22, 23 or 24, **characterised in that** it includes a sheet (83) with marks (30) which can be cut off (50) on one of its faces.

**26.** A process of manufacture according to claim 14,
**characterised in that** the said marks are formed in the pair of photonegative films during the same process in which the corresponding image elements or figures whose outlines surround the image elements are formed and the said centering marks in the dimensionally stable transparent substrate sheet at the same time as the said guiding marks (26) for overall positioning on a roller (41) of the printing machine (35) are printed or engraved.

**27.** A process of manufacture according to claim 1,
**characterised in that** the positions of the said guide and centering indicators on the transparent laminar support are previously determined in a predetermined positional correlation with positioning guides on the roller and the positioning marks located on the two photonegative films respectively, all the marks being correlated by a computer provided with a memory in which a template corresponding to the roller dimensions and guides has previously been stored, this computer being used as the only source for marking the indicators on the transparent laminar substrate and the marks on the photonegative films.

**28.** A process of manufacture according to claim 1,
**characterised in that** the said areas which allow light to pass selectively are formed by corresponding cut-outs (51) made in the said films.

**29.** A process of manufacture according to claim 28,
**characterised in that** the said cut-outs are made by means of a machine controlled by a computer program.

**30.** A process of manufacture according to claim 1,
**characterised in that** the stages of placing the dimensionally stable transparent substrate sheet and applying the second restrictive device above the same are carried out sequentially **in that** order.

**31.** A process of manufacture according to claim 1,
**characterised in that** irradiation is first performed through the restrictor device containing the outline figures defining the bases and then through the restrictor device containing the image elements.

**32.** A process of manufacture according to claim 1,
**characterised in that** irradiation is carried out simultaneously through the two radiating plates to cure the resin in regions corresponding to the said respective image and base elements.

**33.** A process of manufacture according to claim 1,
**characterised in that** at least two laminar printing supports corresponding to different colours or images are manufactured simultaneously on the same substrate sheet, locating the corresponding image elements, the outlines corresponding to each laminar printing support being placed side by side on the two compound restrictor devices in such a way as to cut the dimensionally stable transparent substrate sheet with the plate members formed thereon in the corresponding laminar printing supports.

**34.** A process of manufacture according to claim 1,
**characterised in that** the dimensionally stable transparent substrate sheet and the restrictor devices are immobilised in the marked positions by fixing a first end of the dimensionally stable transparent substrate sheet in position and then securing all the said dimensionally stable transparent substrate sheet with complete securing means.

**35.** A process of manufacture according to claim 34,
**characterised in that** the said end of the dimensionally stable transparent substrate sheet is attached by applying adhesive tape or vacuum and **in that** all the substrate sheet is then secured using mechanically or pneumatically operated securing means.

**36.** A process of manufacture accoding to claim 1,
**characterised by** the additional operating stage of surface protection of the upper surface of the first negative laminar element against the curable material by means of a transparent sheet of protective material prior to the operating stages of covering the said curable material and positioning the transparent laminar element in relation to the dimensionally stable laminar substrate.

**37.** A process of manufacture according to claim 1,
**characterised by** the final operating stages subsequent to those of emitting curing radiation of:
removing the printing support formed by the laminar element of the substrate with the embossed printing elements resulting from the stages of curing by irradiation, and
recovery of the surplus resin on the printing support.

**38.** An irradiating machine for carrying out the process according to any one of claims 1 to 37, to manufacture laminar printing supports, each of which comprise at least one plate representative of a monochromatic portion of an image which has to be printed on laminar materials adhering to the dimensionally stable substrate sheet in a specific position for each image which has to be printed, each plate comprising a base which extends beyond a die shaped to the said monochromatic portion of the image; the said irradiationg machine comprising:
a frame provided with a bottom window below which there is a lower irradiating device,
a cover provided with an upper window above which there is an uppper irradiating device,
means for the injection of fluid which can be set by radiation within the space between the two windows,
a device for unrolling a dimensionally stable sheet onto the said window,
a first retaining device to adhere to the said lower window above the said lower irradiating device, a first filtering film printed with marks corresponding to the monochromatic portions of the said image which has to be printed and
a second retaining device to adhere to the said upper window below the said upper irradiating device, a second filtering film printed with figures enclosing the marks corresponding to the said monochromatic portions printed on the said first filtering film, and
**characterised in that** in the said irradiating machine general positioning marks distributed horizontally and used to position the dimensionally stable substrate sheet and the two filtering films in vertical register with one another are marked in the same way as the two filtering films so that the machine is capable of producing a complete laminar printing support in a process of manufacture according to any one of the preceding claims.

**39.** An irradiating machine according to claim 38,
chracterised in that the said marks comprise marks at the side of the said window which include a first set close to one end where the carriage rests before pouring the resin and rolling out the sheet and a second set of marks further within the said window from where the said carriage rests.

**40.** An irradiating machine according to claim 39,
**characterised in that** the said marks include a third set of marks close to the extremity opposite that where the said carriage rests before pouring the resin and unrolling the sheet.

**41.** An irradiating machine according to claim 38, 39 or 40, **characterised in that** it comprises vacuum retaining means capacble of immobilising the said photonegative films against the corresponding transparent windows of the base and cover of the irradiating machine.

**42.** A printing support for rollers for the printing of laminar materials manufactured according to claims 1 to 37, **characterised in that** it comprises a transparent dimensionally stable laminar support, one of the faces of which is intended to coincide exactly with the external surface of the cylindrical core of a printing roller, fixed marks on the support coinciding with fixed marks on the roller, while the other surface has embossed printing members each of which is formed by a base of little height from which there extends in dimensionally adjusted form the body bearing the graphic image or die, the thickness of the laminar support being between 200 µm and 500 µm (microns).

**43.** A printing support according to claim 42,
**characterised in that** it comprises a polyester laminar support.

**44.** A printing support according to claim 43,
**characterised in that** the thickness of the laminar support is approximately 350 µm.

**45.** A printing support according to claim 42,
**characterised in that** each base of a projecting die bearing the graphic image being printed comprises an outline which exceeds the corresponding die or projection bearing the graphic printing image by approximately 10 to 20 mm.

**46.** A process for the manufacture of rollers for the printing of laminar materials of the type comprising a roller cylindrical core with a laminar support bearing embossed individual printing dies or plates, **characterised in that** once the printing support formed by the laminar substrate element and the embossed printing element resulting from the stages of curing by irradiation manufactured according to the process in claim 1 has been removed it is wrapped around the cylindircal core of the roller with positional accuracy making the guide indicators previously provided on the transparent laminar element acting as a substrate coincide with the guides of the printing roller.

**47.** A roller for the printing of laminar materials of the type comprising a cylindrical core, **characterised by** a laminar support bearing embossed individual printing dies or plates manufactured according to the process in claim 1 and mounted on the cylindrical core of the roller with positional accuracy.
